(19) Europäisches Patentamt
European Patent Office
Office européen des brevets

(11) Veröffentlichungsnummer: **0 423 384 B1**

(12) # EUROPÄISCHE PATENTSCHRIFT

(45) Veröffentlichungstag der Patentschrift: **28.07.93**

(51) Int. Cl.5: **B66B 1/06**

(21) Anmeldenummer: **89119192.6**

(22) Anmeldetag: **16.10.89**

(54) **Steuerungsvorrichtung für Aufzuganlage ohne Geschwindigkeitsfühler.**

(43) Veröffentlichungstag der Anmeldung:
**24.04.91 Patentblatt 91/17**

(45) Bekanntmachung des Hinweises auf die
Patenterteilung:
**28.07.93 Patentblatt 93/30**

(84) Benannte Vertragsstaaten:
**AT CH DE ES FR GB IT LI**

(56) Entgegenhaltungen:
**GB-A- 1 112 846          GB-A- 2 061 559**
**GB-A- 2 149 586          US-A- 3 460 014**
**US-A- 3 989 991          US-A- 4 713 595**

(73) Patentinhaber: **OTIS ELEVATOR COMPANY**
**Four Farm Springs**
**Farmington Connecticut 06032(US)**

(72) Erfinder: **Horbrügger, Herbert Karl**
**Kirchstrasse 19**
**W-1000 Berlin 21(DE)**
Erfinder: **Eichberger, Jost-Ingo**
**Hessenallee 11**
**W-1000 Berlin 19(DE)**

(74) Vertreter: **Henkel, Feiler, Hänzel & Partner**
**Möhlstrasse 37**
**W-8000 München 80 (DE)**

EP 0 423 384 B1

**Beschreibung**

Die Erfindung betrifft eine Steuerungsvorrichtung für eine Aufzuganlage ohne Geschwindigkeitsfühler, mit einem Induktionsmotor zum Antreiben einer Fahrstuhlkabine, die sich an ein durch eine Markierung gegebenes Stockwerkniveau ab einer Vormarkierung mit Verzögerungsgeschwindigkeitsprovil annähert, und einem VVVF-Inverter, der den Induktionsmotor mit Strom versorgt.

Zur Verbesserung des Fahrkomforts in Ein oder Zwei-Geschwindigkeitsaufzuganlagen kann ein VVVF-Wechselrichter eingesetzt werden, der hinsichtlich des mechanischen Aufwandes eine sehr kostengünstige Lösung bietet, da keine Geschwindigkeitsfühler benötigt werden, die sonst üblicherweise eingesetzt werden, um ein möglichst genaues Annähern an ein Stockwerkniveau zu gewährleisten.

Eine derartige Steuerungsvorrichtung für eine Aufzuganlage ohne Geschwindigkeitsfühler ist beispielsweise in der US-PS 4 680 526 beschrieben. Bei dieser Steuerungsvorrichtung wird ein Induktionsmotor durch einen Inverter angetrieben. Der in den Induktionsmotor fließende Primärstrom wird gemessen. Aufgrund dieses Primärstromes werden Drehmoment und Schlupf ermittelt. Abhängig von dem so bestimmten Schlupf werden wiederum Ausgangsspannung und Frequenz des Inverters gesteuert. Zusätzlich wird die Drehzahl des Induktionsmotores abhängig von dem ermittelten Drehmomentstrom geschätzt, und die Drehzahl des Induktionsmotores wird so gesteuert, daß das geschätzte Drehzahlsignal mit der Soll-Drehzahl übereinstimmt.

Der Aufwand für eine derartige Steuerungsvorrichtung ist beträchtlich hoch. Zusätzlich müssen Positionskontakte eingesetzt werden, um ein genaues Annähern der Fahrstuhlkabine an ein Stockwerkniveau zu gewährleisten.

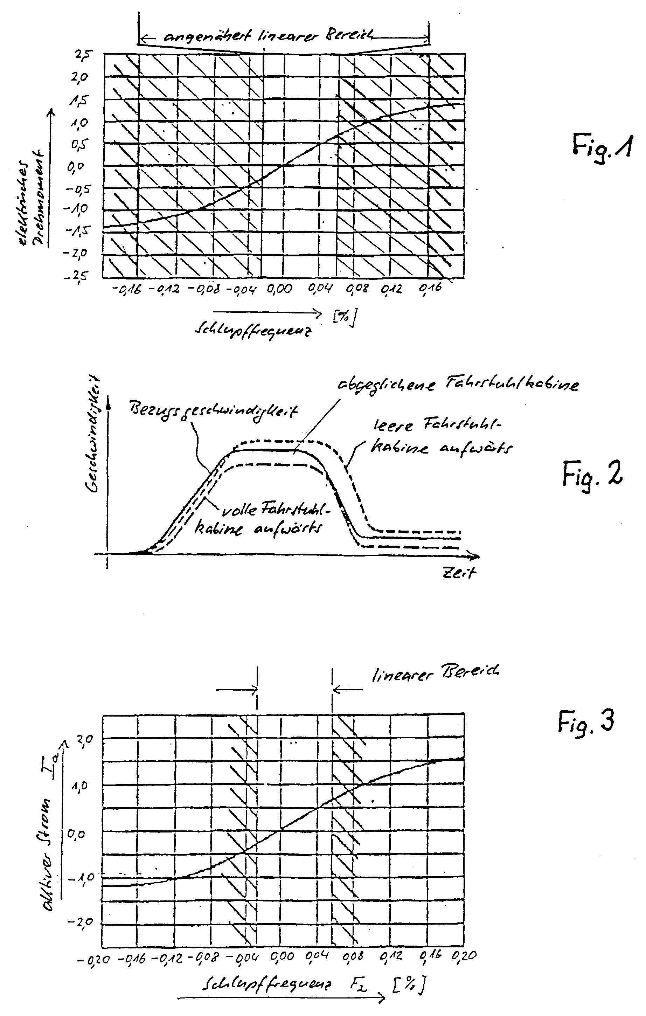

Für den Fahrkomfort ist es nun nicht immer notwendig, ständig die Geschwindigkeit der Fahrstuhlkabine in einer geschlossenen Schleife zu regeln. Damit der Motor das gewünschte Drehmoment bei jeder Statorfrequenz abzugeben vermag, muß nur der Motorfluß gesteuert werden. Für Drehmoment und Schlupf wird so eine Beziehung erhalten, die innerhalb eines gewissen Bereiches in erster Näherung durch eine Gerade angenähert werden kann. Ein Beispiel hierfür ist in der Fig. 1 gegeben, in der auf der Abszisse die Schlupffrequenz und auf der Ordinate des elektrische Drehmoment aufgetragen sind.

Die Forderungen für Beschleunigung und Abbremsung können mittels eines geeigneten Bezugsfrequenzprofiles erfüllt werden. Infolge der Abhängigkeit von Drehmoment und Schlupf des Motores hängt aber die Geschwindigkeit der Fahrstuhlkabine vom Lastzustand ab. Daher ist für die Niveauannäherung ein Bezugsprofil notwendig, das in einem Schleichgeschwindigkeitsabschnitt endet. In der Fig. 2 ist ein solches Profil gezeigt, wobei auf der Abszisse die Zeit und auf der Ordinate die Geschwindigkeit aufgetragen sind. Die Genauigkeit der Niveauannäherung hängt von der Schleichgeschwindigkeit ab, und es wird eine bestimmte Mindestfahrzeit benötigt, um auch im schlechtesten Fall einen ausreichenden Schleichabstand sicherzustellen.

Es ist nun Aufgabe der vorliegenden Erfindung, eine Steuerungsvorrichtung für eine Aufzuganlage ohne Geschwindigkeitsfühler zu schaffen, bei der eine Niveauannäherung möglichst genau erfolgt und bei der außerdem der Schleichgeschwindigkeitsabschnitt gering ist.

Diese Aufgabe wird bei einer Steuerungsvorrichtung nach dem Oberbegriff des Patentanspruches 1 erfindungsgemäß dadurch gelöst, daß der VVVF-Inverter den dem Induktionsmotor zugeführten Wirkstrom mißt, wenn die Fahrstuhlkabine mit konstanter Geschwindigkeit vor Erreichen der Vormarkierung fährt, daß weiterhin eine Schlupf-Kompensationseinheit aus dem gemessenen Wirkstrom eine zugehörige Schlupffrequenz ermittelt und aus dieser die Schleichgeschwindigkeit bis zur nächsten Markierung ableitet, daß in einem Speicher eine die Schleichzeit angebende Funktion abhängig vom gemessenen Wirkstrom gespeichert wird, daß eine Recheneinheit aus der Schleichzeit eine Verzögerungszeit berechnet, um die der Beginn des Abbremsungsvorganges der Fahrstuhlkabine bei jeder Fahrt verzögert wird, und unter Berücksichtigung der so berechneten Verzogerungszeit nach jeder Fahrt eine neue virtuelle fortgeschriebene Schleichzeit ermittelt, und daß schließlich ein Profilgenerator den VVVF-Inverter mit einem Spannungs/Frequenzsignal abhängig von der virtuellen forgeschriebenen Schleichzeit ansteuert.

Bei der erfindungsgemäßen Steuerungsvorrichtung wird also während des Betriebs mit konstanter Geschwindigkeit der Wirkstrom bzw. aktive Strom des Motores gemessen. Dies kann beispielsweise durch Messen von Phasenwinkel und Stromgröße in einer Motorleitung oder durch Messung des Umrichterzwischenkreisstroms geschehen. Der Wirkstrom steht mit der Schlupffrequenz in einem in Fig. 3 gezeigten Zusammenhang, in welcher auf der Abszisse die Schlupffrequenz und auf der Ordinate der Wirkstrom aufgetragen sind. Diese Abhängigkeit kann in erster Linie durch eine lineare Funktion innerhalb eines Nennbetriebsbereiches angenähert werden.

Damit ist es möglich, die Bezugsgröße der Schleichgeschwinigkeit durch eine Abschätzung der Schlupffrequenz zu korrigieren, welche aus der Messung des Wirkstromes abgeleitet ist. Dies führt zu einer Verringerung des Geschwindigkeitsfehlers während der Schleichphase und damit zu einer höheren Genauigkeit der Niveauannäherung der Fahrstuhlkabine.

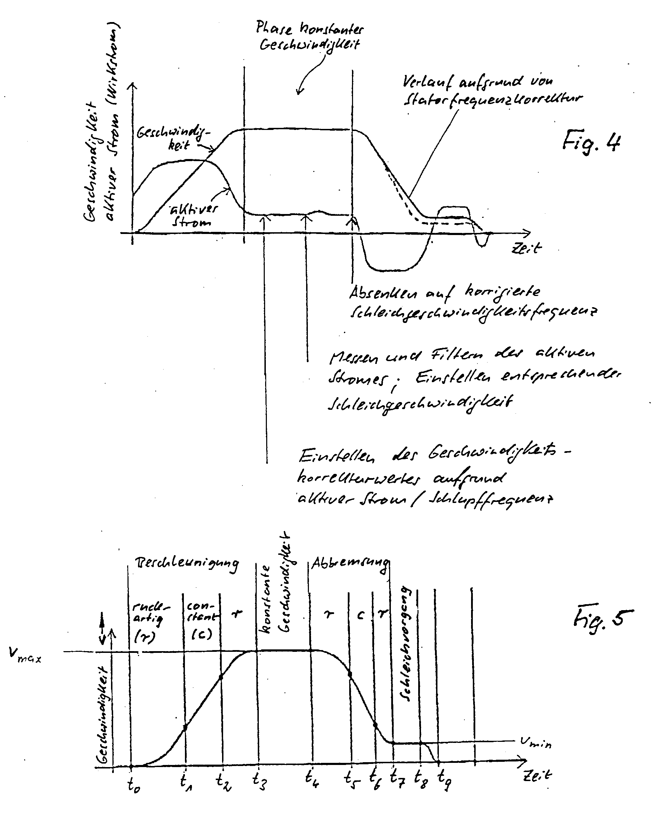

In Fig. 4, in der für den Lastfall "volle Kabine aufwärts" auf der Abszisse die Zeit und auf der Ordinate die Geschwindigkeit bzw. der aktive Strom aufgetragen sind, ist dieses Kompensationsprinzip näher gezeigt: Der Wirkstrom hat während des Beschleunigungsvorgangs einen relativ großen Wert und nimmt während der Stationärfahrt einen geringeren, von der Last und Reibung abhängigen Wert an. Während des Abbremsungsvorganges kann, wie dargestellt, sich die Richtung des Wirkstromes umkehren, um dann während des Schleichvorganges wieder etwa den Stationärwert bei Nenngeschwindigkeit anzunehmen.

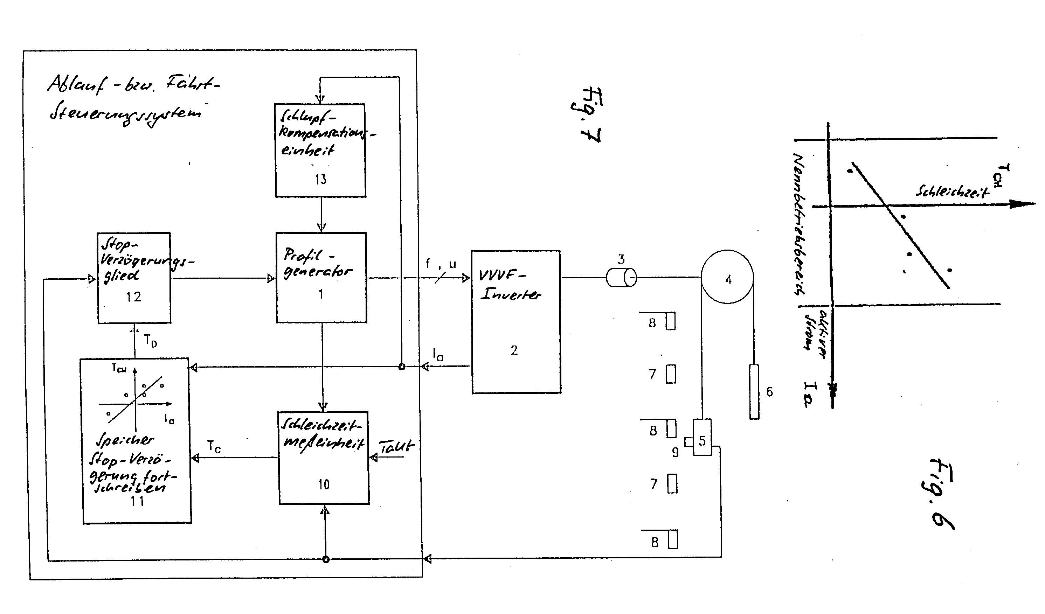

Die Schleichzeit ist die Differenz zwischen dem Ende des Abbremsungsabschnittes, gegeben durch den Zeitpunkt beim Erreichen des stationären Sollfrequenzpofils, und dem Zeitpunkt, in welchem die Fahrstuhlkabine an einer Niveaumarkierung vorbeifährt. In Fig. 5 ist die Schleichzeit zwischen den Zeitpunkten T7 und T8 gelegt. In dieser Fig. 5 sind auf der Abszisse die Zeit und auf der Ordinate die Geschwindigkeit der Fahrstuhlkabine aufgetragen. Das heißt, Fig. 5 zeigt ein Geschwindigkeitsprofil für die Fahrstuhlkabine.

Die Meßwerte für den Wirkstrom, die während des Betriebes mit konstanter Geschwindigkeit gemessen werden, und die sich aus dem Schleichvorgang am Ende der Aufzugsfahrt ergebende Schleichzeit werden in einem Speicher abgespeichert. Nach Abschluß einer Fahrt nimmt die Steuerungsvorrichtung eine Annäherung für die Beziehung zwischen dem Wirkstrom und den gemessenen Schleichzeiten vor. Damit wird eine Schleichzeitfunktion erhalten, wie diese in Fig. 6 gezeigt ist, in der auf der Abszisse der Wirkstrom und auf der Ordinate verschiedene Schleichzeiten aufgetragen sind.

Für zukünftige Fahrten der Fahrstuhlkabine wird diese Schleichzeitfunktion verwendet, um ein Steuersignal zu verzögern, das den Abbremsungsprozeß einleitet. Daher kann die Verzögerungszeit entsprechend der Schleichzeit durch die folgende Gleichung ausgedrückt werden:

$$Td = Tc \ (Vc/Un)$$

mit

    $Td$ = Verzögerungszeit für Beginn des Abbremsungsprozesses,
    $Vc$ = Schleichgeschwindigkeit,
    $Vn$ = Nenngeschwindigkeit und
    $Tc$ = Schleichzeit.

Fortschreibungen der Schleichzeitfunktion erfolgen mittels einer virtuellen Schleichzeit $Tcv$, die die letzte Stop-Verzögerungszeit $Td1$ umfaßt. Es liegt dabei folgende Abhängigkeit vor:

$$Tcv = Tcm + Td1 \ (Vn/Vc)$$

mit $Tcv$ = virtuelle Schleichzeit,
$Tcm$ = gemessene Schleichzeit,
$Td1$ = in entsprechender Fahrt verwendete Verzögerungszeit.

Auf diese Weise wird die Kompensationsfunktion nach jeder Fahrt der Fahrstuhlkabine ergänzt. Jegliche Parameterveränderung der Aufzugsanlage, wie beispielsweise in einer Änderung des Reibung des Getriebes oder eine Temperaturänderung, die den Zusammenhang zwischen Drehmoment und Schlupf des Motors beeinflußt, werden durch das Fortschreiben der Schleichzeitkurve automatisch berücksichtigt.

Zur Anpassung an zeitveränderliche Parameter der Aufzuganlage kann diese Funktion noch gewichtet werden.

Nachfolgend wird die Erfindung anhand der Zeichnungen näher erläutert. Es zeigen:

    Fig. 1    die Abhängigkeit des elektrischen Drehmomentes von der Schlupffrequenz,
    Fig. 2    ein Geschwindigkeitsprofil bei festem unverändertem Frequenzsollprofil,
    Fig. 3    die Abhängigkeit des Wirkstromes von der Schlupffrequenz,
    Fig. 4    den Verlauf der Geschwindigkeit bei einer Fahrt der Fahrstuhlkabine sowie die entsprechenden Größen des Wirkstromes,
    Fig. 5    ein weiteres Geschwindigkeitsprofil,
    Fig. 6    die Abhängigkeit der Schleichzeit vom Wirkstrom und
    Fig. 7    ein Blockdiagramm für ein Ausführungsbeispiel der Erfindung.

Die Fig 1 bis 6 sind bereits oben erläutert worden.

Fig. 7 zeigt schematisch eine Fahrstuhlkabine 5, die über ein Drahtseil mit einem Gegengewicht 6 verbunden ist. Das Drahtseil ist über eine Rolle 4 geführt, welche von einem Induktionsmotor 3 angetrieben wird. Markierungen 7 geben an, wenn vor Erreichen einer Stockwerk-Markierung 8 ein Abbremsvorgang einzuleiten ist.

Der Induktionsmotor 3 wird über einen VVVF-Inverter 2 angetrieben. In diesem VVVF-Inverter 2 wird der Wirkstrom Ia gemessen, welcher dem Induktionsmotor 3 zugeführt ist. Aus diesem Wirkstrom Ia kann die Schlupffrequenz abgeleitet werden, wie dies oben erläutert wurde. Abhängig von dem so ermittelten Wirkstrom Ia nimmt eine Schlupfkompensationseinheit 13 eine Schlupfkompensation vor.

Eine Schleichzeitmeßeinheit 10 mißt die Schleichzeit der Fahrstuhlkabine 5 und gibt ein entsprechendes Signal an einen Speicher 11 ab. In diesem Speicher 11 sind Wertepaare für die Abhängigkeit der Schleichzeit vom Wirkstrom Ia gespeichert.

Ein Stop-Verzögerungsglied 12 berechnet eine Verzögerungszeit aus der Schleichzeit und steuert einen Profilgenerator 1 an, der wiederum ein Signal einer entsprechenden Frequenz und Spannung an den VVVF-Inverter 2 anlegt, damit dieser den Induktionsmotor 3 abhängig von der fortgeschriebenen Verzögerungszeit ansteuert.

**Patentansprüche**

1. Steuerungsvorrichtung für Aufzuganlage ohne Geschwindigkeitsfühler, mit
   - einem Induktionsmotor (3) zum Antreiben einer Fahrstuhlkabine (5), die sich an ein durch eine Markierung (8) gegebenes Stockwerkniveau ab einer Vormarkierung (7) mit einem Verzögerungsgeschwindigkeitsprofil annähert, und
   - einem VVVF-Inverter (2), der den Induktionsmotor (3) mit Strom versorgt, dadurch gekennzeichnet, daß
   - der VVVF-Inverter (2) den dem Induktionsmotor (3) zugeführten Wirkstrom (Ia) mißt, wenn die Fahrstuhlkabine (5) mit konstanter Geschwindigkeit vor Erreichen der Vormarkierung (7) fährt,
   - eine Schlupf-Kompensationseinheit (13) aus dem gemessenen Wirkstrom eine zugehörige Schlupffrequenz ermittelt und aus dieser die Schleichgeschwindigkeit (Vc) bis zur nächsten Markierung (8) ableitet,
   - in einem Speicher (11) eine die Schleichzeit (Tc) angebende Funktion abhängig vom gemessenen Wirkstrom gespeichert wird,
   - eine Recheneinheit (12) aus der Schleichzeit (Tc) eine Verzögerungszeit (Td) berechnet, um die der Beginn des Abbremsungsvorganges der Fahrstuhlkabine (5) bei jeder Fahrt verzögert wird, und unter Berücksichtigung der so berechneten Verzögerungszeit (Td) nach jeder Fahrt eine neue virtuelle fortgeschriebene Schleichzeit (Tcv) ermittelt, und
   - ein Profilgenerator (1) den VVVF-Inverter (2) mit einem Spannungs/Frequenzsignal (f, u) abhängig von der virtuellen fortgeschriebenen Schleichzeit (Tcv) ansteuert.

2. Steuerungsvorrichtung nach Anspruch 1, dadurch gekennzeichnet, daß die virtuelle fortgeschriebene Schleichzeit Tcv nach folgender Gleichung ermittelt wird:

$$Tcv = Tcm + Td \cdot \frac{Vn}{Vc}$$

mit
   Tcm = gemessene Schleichzeit,
   Td = Verzögerungszeit,
   Vn = Nenngeschwindigkeit der Fahrstuhlkabine
   Vc = Schleichgeschwindigkeit der Fahrstuhlkabine.

**Claims**

1. Control device for an elevator installation without speed sensor, having
   - an induction motor (3) for driving a lift car (5) which, from an advance marking (7), approaches a floor level determined by a marking (8) with a deceleration speed profile, and
   - a VVVF inverter (2), which supplies the induction motor (3) with current, characterised in that
   - the VVVF inverter (2) measures the active current (Ia) fed to the induction motor (3) when the lift car (5) is travelling at constant speed before reaching the advance marking (7),
   - a slip-compensation unit (13) establishes from the active current measured an associated slip frequency and derives from this the creeping speed (Vc) up to the next marking (8),
   - a function determining the creeping time (Tc), dependent on the active current measured, is stored in a memory (11),
   - an arithmetic unit (12) calculates from the creeping time (Tc) a delay time (Td) by which the beginning of the deceleration function of the lift car (5) is delayed in each journey, and after each journey establishes a new virtual updated creeping time (Tcv), taking into account the delay time (Td) thus calculated, and
   - a profile generator (1) drives the VVVF inverter (2) with a voltage/frequency signal (f, u) dependent on the virtual updated creeping time (Tcv).

2. Control device according to Claim 1, characterised in that the virtual updated creeping time Tcv is established by the following equation:

$$Tcv \; = \; Tcm \; + \; Td \; \cdot \; \frac{Vn}{Vc}$$

where

Tcm = measured creeping time,
Td = delay time,
Vn = nominal speed of the lift car,
Vc = creeping speed of the lift car.

**Revendications**

1. Dispositif de commande pour un système d'ascenseur sans capteur de vitesse, comportant :
   - un moteur à induction (3) pour entraîner une cabine d'ascenseur (5), qui se rapproche du niveau d'un étage défini par un repère (8) à partir d'un repère préalable (7) suivant un certain profil de vitesse de ralentissement,
   - et un convertisseur de courant (2) de type VVVF, qui alimente en courant le moteur à induction (3),
   caractérisé en ce que :
   - le convertisseur VVVF (2) mesure la valeur de l'intensité (Ia) du courant actif envoyé au moteur à induction (3), lorsque la cabine d'ascenseur (5) se déplace à une vitesse constante avant d'atteindre le repère préalable (7),
   - une unité de compensation de glissement (13) est prévue pour élaborer une valeur appropriée de fréquence de glissement à partir de la valeur mesurée de l'intensité du courant actif et en déduit la valeur (Vc) de la vitesse d'accostage jusqu'au repère (8) le plus voisin,
   - une unité de calcul (12) est prévue pour calculer une durée de ralentissement (Td) d'après la durée d'accostage (Tc), afin de fixer le début de la manoeuvre de freinage de la cabine d'ascenseur (5) pour chaque mouvement de celle-ci, et pour déterminer après chaque mouvement de la cabine une nouvelle valeur virtuelle révisée de la durée d'accostage (Tcv) en tenant compte de la durée de ralentissement ainsi calculée,
   - un générateur de profil (1) est prévu pour commander le convertisseur VVVF (2) au moyen d'un signal(f,u) de tension/fréquence, en fonction de la valeur virtuelle révisée de la durée d'accostage (Tcv).

2. Dispositif de commande selon la revendication 1, caractérisé en ce que la valeur virtuelle révisée de la durée d'accostage (Tcv) est calculée d'après l'équation ci-après :

$$Tcv \; = \; Tcm \; + \; Td \; . \; \frac{Vn}{Vc}$$

dans laquelle :

Tcm = Valeur mesurée de la durée d'accostage
Td = Durée de ralentissement
Vn = Vitesse nominale de la cabine d'ascenseur
Vc = Vitesse d'accostage de la cabine d'ascenseur.

Fig. 1

Fig. 2

Fig. 3

Fig. 4

Phase konstanter Geschwindigkeit

Verlauf aufgrund von Statorfrequenzkorrektur

Geschwindigkeit aktiver Strom (Wirkstrom)

Geschwindigkeit

aktiver Strom

Zeit

Absenken auf korrigierte Schleichgeschwindigkeitsfrequenz

Messen und Filtern des aktiven Stromes; Einstellen entsprechender Schleichgeschwindigkeit

Einstellen des Geschwindigkeits-korrekturwertes aufgrund aktiver Strom / Schlupffrequenz

Fig. 5

Beschleunigung

Abbremsung

ruck-artig (r)

con-stant (c)

r

konstante Geschwindigkeit

r

c

r

Schleichvorgang

$V_{max}$

Geschwindigkeit

$v_{min}$

$t_0$  $t_1$  $t_2$  $t_3$  $t_4$  $t_5$  $t_6$  $t_7$  $t_8$  $t_9$

Zeit

Fig. 6

Fig. 7